# EUROPÄISCHE PATENTSCHRIFT

(11) **EP 2 286 248 B1**
(45) Veröffentlichungstag und Bekanntmachung des Hinweises auf die Patenterteilung: **03.01.2018**
(21) Anmeldenummer: 09757149.1
(22) Anmeldetag: 21.04.2009
(51) Int. Cl.: G01R 1/04, G01R 1/067, G01R 23/163, G01R 27/32

(54) **SYSTEM ZUM MESSEN VON HOCHFREQUENZSIGNALEN MIT NORMIERTER STROMVERSORGUNGS- UND DATENSCHNITTSTELLE**
SYSTEM FOR MEASURING HIGH-FREQUENCY SIGNALS HAVING STANDARDIZED POWER SUPPLY AND DATA INTERFACE
SYSTÈME DESTINÉ À MESURER DES SIGNAUX HAUTE FRÉQUENCE ET ÉQUIPÉ D'UNE INTERFACE NORMALISÉE D'ALIMENTATION ÉLECTRIQUE ET DE DONNÉES

(30) Priorität: 06.06.2008 DE 102008027031; 30.07.2008 DE 102008035374
(43) Veröffentlichungstag der Anmeldung: 23.02.2011
(73) Patentinhaber: Rohde & Schwarz GmbH & Co. KG, 81671 München (DE)
(72) Erfinder: PESCHKE, Martin, 81549 München (DE); BRATFISCH, Toralf, 85640 Putzbrunn (DE); BENISCH, Christian, 86199 Augsburg (DE)
(74) Vertreter: Körfer, Thomas
(86) Internationale Anmeldenummer: PCT/EP2009/002889
(87) Internationale Veröffentlichungsnummer: WO 2009/146765

(56) Entgegenhaltungen:
- EP-A- 1 209 472
- EP-A- 1 801 699
- WO-A-2009/071156
- US-B1- 6 402 565
- "Real-time Spectrum Analyzer TekConnect TM Probe Adapter" INTERNET CITATION, [Online] 15. Juni 2005 (2005-06-15), Seiten 1-2, XP007909951 Gefunden im Internet: URL:http://www2.tek.com/cmswpt/psdetails.l otr?ct=PS&cs=psu&ci=13419&lc=EN> [gefunden am 2009-09-29]

## Beschreibung

Die Erfindung betrifft ein System zum Messen von Hochfrequenzsignalen mit normierter Stromversorgungs- und Datenschnittstelle zwischen Messgerät und Breitbandtastkopf.

Aktive Breitbandtastköpfe mit Erfassungsbandbreiten über mehrere Giga-Hertz, wie sie bei modernen Echtzeit-Oszilloskopen zum Einsatz kommen, weisen eine hybride Schnittstelle bestehend aus Hochfrequenzsignalleitungen und Niederspannungssignalleitungen für die Stromversorgung und die Ansteuerung des Breitbandtastkopfs sowie für das Auslesen von Zuständen des Breitbandtastkopfes zum Messgerät auf.

Für gewöhnlich wird vom Hersteller des Breitbandtastkopfes eine proprietäre - d.h. herstellerspezifische und nicht standardisierte - Schnittstelle, wie sie beispielsweise in der US 6,402,565 B1 offenbart ist, zur Verbindung des Breitbandtastkopfes mit dem jeweiligen Messgerät geschaffen.

Wird ein Breitbandtastkopf aus Kosten- und Flexibilitätsgründen nicht nur für einen bestimmten Typ eines Echtzeit-Oszilloskops, sondern für ein weites Spektrum von Echtzeit-Oszilloskopen wie auch für andere Messgeräte, beispielsweise Sampling-Oszilloskope, Spektrumanalysatoren, Netzwerkanalysatoren, oder Gleichspannungs-Voltmeter, eingesetzt, stimmt die tastkopfseitige Schnittstelle in der Regel nicht mit der messgeräteseitigen Schnittstelle überein.

Hinzu kommt, dass für die Kalibrierung eines Breitbandtastkopfes zusätzliche Messgeräte, Steuergeräte, Versorgungsspannungsgeräte und Adapterbaugruppen erforderlich sind.

Relevante Dokumente aus dem Stand der Technik sind EP 1 801 699 A und "Real-time Spectrum Analyzer TekConnect TM Probe Adapter", 15. Juni 2005 (2005-06-15), XP007909951 sowie EP 1 209 472 A.

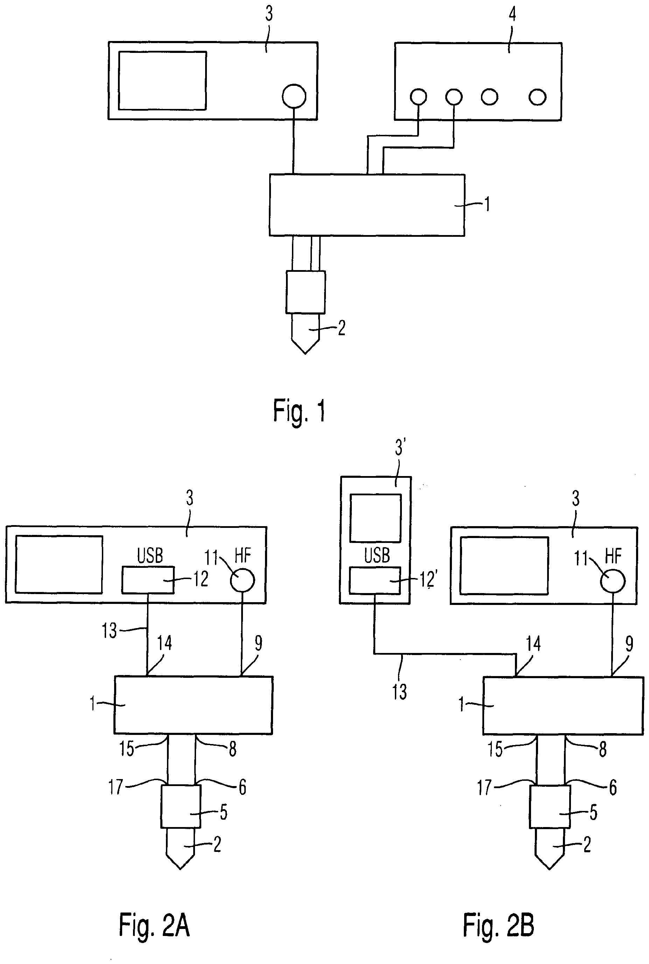

Fig. 1 zeigt eine bei der Anmelderin bislang übliche Adaptierung mit externem Stromversorgungsgerät. Das Erfordernis einer Vielzahl von Adapterbaugruppen 1 und zusätzlicher Messgeräte, Steuergeräte und Versorgungsspannungsgeräte 4 zum Anschluss eines bestimmten Breitbandtastkopfes 2 an unterschiedliche Messgeräte 3 und zur Kalibrierung des Breitbandtastkopfes 2 gemäß Fig. 1 verteuern die Gesamt-Anschaffungskosten gegenüber den Anschaffungskosten einzig eines Breitbandtastkopfes um ein Vielfaches.
Aufgabe der Erfindung ist es deshalb, eine kostengünstige technische Lösung zur Verwendung eines Breitbandtastkopfes an unterschiedlichen Messgerätetypen zu schaffen, die gleichzeitig ein kostengünstiges Kalibrieren des Breitbandtastkopfes ermöglicht.

Die Erfindungsaufgabe wird durch ein System zum Messen eines Hochfrequenzsignals mit den Merkmalen des Patentanspruchs 1 gelöst. Sinnvolle technische Weiterbildungen sind in den abhängigen Ansprüchen angegeben.
Erfindungsgemäß wird eine normierte Schnittstelle für die Stromversorgung des jeweiligen aktiven Breitbandtastkopfes und für die Datenkommunikation zwischen dem jeweiligen Messgerät oder der jeweiligen Signalverarbeitungs-Einheit und dem jeweiligen Breitbandtastkopf genutzt. Die Stromversorgungsanschlüsse und Datensignalanschlüsse sind mit identischer Signalbelegung und Signalspezifikation bei jeder im Messsystem verwendeten Funktions-Einheit, also bei jedem Messgerät, jeder Signalverarbeitungs-Einheit und jedem Breitbandtastkopf ausgelegt. Zusätzlich ist eine identische Führung der mechanischen Stromversorgungsanschlüsse und Datensignalanschlüsse in einer normierten Buchse bei jedem Messgerät und bei jeder Signalverarbeitungs-Einheit und entweder beim Breitbandtastkopf oder bei einer mit dem Breitbandtastkopf elektrisch verbundenen Adapterbaugruppe gefordert. Die Adapterbaugruppe ist vorzugsweise eine passive Baugruppe ohne eigene Stromversorgung.

Über die Datensignalanschlüsse werden Signale der Datenkommunikation zwischen Messgerät bzw. Signalverarbeitungs-Einheit und Breitbandtastkopf, beispielsweise die Ansteuersignale und gemessene Kalibrierdaten für den Breitbandtastkopf und die gespeicherten Kalibrierdaten, Statussignale und/oder Gleichspannungs-Messsignale des Breitbandtastkopfes, geführt.

Entsprechen die mechanischen Stromversorgungs- und Datensignalanschlüsse des jeweiligen Breitbandtastkopfes nicht dieser normierten Schnittstelle, so ist bevorzugt auf der Adapterbaugruppe für den jeweiligen Breitbandtastkopf eine Signalumsetzung zwischen ersten mechanischen Stromversorgungs- und Datensignalanschlüssen, die mit den normierten mechanischen Stromversorgungs- und Datensignalanschlüssen des jeweils benutzten Messgeräts oder der jeweils benutzten Signalverarbeitungs-Einheit elektrisch verbunden sind und ebenfalls in einer einzigen identisch normierten Buchse geführt sind, und mit den ersten mechanischen Stromversorgungs- und Datensignalanschlüssen elektrisch verbundenen zweiten mechanischen Stromversorgungs- und Datensignalanschlüssen, die mit den mechanischen Stromversorgungs- und Datensignalanschlüssen des jeweiligen Breitbandtastkopf elektrisch verbunden sind, vorgesehen.

Auf diese Weise kann jeder beliebige Breitbandtastkopf an jedes beliebige Messgerät und jede beliebige Signalverarbeitungs-Einheit, die jeweils eine derart normierte Schnittstelle für die Stromversorgungs- und Datensignalanschlüsse aufweist, angeschlossen werden. Der Breitbandtastkopf ist somit universeller einsetzbar. Auch muss vorteilhaft nur noch eine einzige Adapterbaugruppe vorgehalten werden, die über die normierte Schnittstelle für die Stromversorgungs- und Datensignalanschlüsse mit jedem eine derartige normierte Schnittstelle enthaltenden Messgerät bzw. Signalverarbeitungs-Einheit verbunden werden kann.

Messgeräte und Signalverarbeitungs-Einheiten verfügen vorzugsweise über ein universelles standardisiertes Betriebssystem, so dass das Messgerät oder die Signalverarbeitungs-Einheit über eine geeignete Treiber-Software auf den Breitbandtastkopf wie auf jedes Peripheriegerät zugreifen kann. Die Erzeugung der Ansteuersignale und der Kalibrierdaten und das Auslesen der Statusdaten, der Kalibrierdaten und der Gleichspannungs-Messsignale gestaltet sich in diesem Fall besonders einfach.

Hinzu kommt, dass für die Kalibrierung des Breitbandtastkopfes das Messgerät oder die Signalverarbeitungs-Einheit über die Datensignalanschlüsse der normierten Schnittstelle die für die Kalibrierung des Breitbandtastkopfes erforderliche, im Breitbandtastkopf sich einstellende Gleichspannung empfängt und den Breitbandtastkopf über die Datensignalanschlüsse der normierten Schnittstelle mit geeigneten Kalibrierdaten versorgt. Auf diese Weise ist für die Kalibrierung des Breitbandtastkopfes kein zusätzliches Versorgungsspannungsgerät und/oder Steuergerät zur Versorgung des Breitbandtastkopfes und zur Kommunikation mit dem Breitbandtastkopf erforderlich.

Entsprechen die Hochfrequenzanschlüsse der verwendeten Messgeräte nicht den Hochfrequenzanschlüssen des zugehörigen Breitbandtastkopfes, so erfolgt auf der Adapterbaugruppe in analoger Weise zur Signalumsetzung der Versorgungsspannung und der Datensignale eine Signaladaption des Hochfrequenzsignals zwischen ersten Hochfrequenzanschlüsse, die mit den jeweiligen Hochfrequenzanschlüssen des jeweiligen Messgeräts elektrisch verbunden sind, und mit den ersten Hochfrequenzanschlüssen elektrisch verbundenen zweiten Hochfrequenzanschlüssen, die mit den zugehörigen Hochfrequenzanschlüssen des jeweiligen Breitbandtastkopfes elektrisch verbunden sind.

Die normierte Schnittstelle der Stromversorgungs- und Datensignalanschlüsse entspricht bevorzugt dem Universal-Serial-Bus-(USB)-Standard. Die Hochfrequenzanschlüsse sind messgeräteseitig typischerweise als SMA- oder N-Hochfrequenzanschlüsse und tastkopfseitig typischerweise als BNC-Hochfrequenzanschlüsse ausgeführt.

Die Signalverarbeitungs-Einheit kann ein Personal Computer, Laptop, Server und/oder Micro-Controller-Board mit einer integrierten Universal-Serial-Bus-(USB)-Schnittstelle mit Display-Möglichkeit zur Erzeugung der Versorgungsspannung und von Ansteuersignalen sowie zum Lesen und Schreiben von Kalibrierdaten und zur Erfassung und Darstellung von im Breitbandtastkopf sich einstellenden Statussignalen bzw. Gleichspannungs-Messsignalen sein.

Bevorzugte Ausführungsformen des erfindungsgemäßen Systems zum Messen von Hochfrequenzsignalen mit normierter Stromversorgungs- und Datenschnittstelle zwischen Messgerät und Breitbandtastkopf werden im Folgenden anhand der Zeichnung im Detail erläutert. Die Figuren der Zeichnung zeigen:
- Fig. 1: ein Blockdiagramm eines bisher verwendeten Systems zum Messen von Hochfrequenzsignalen,
- Fig. 2A: ein Blockdiagramm einer ersten Ausführungsform des erfindungsgemäßen Systems zum Messen von Hochfrequenzsignalen mit normierter Stromversorgungs- und Datenschnittstelle zwischen Messgerät und Breitbandtastkopf,
- Fig. 2B: ein Blockdiagramm einer zweiten Ausführungsform des erfindungsgemäßen Systems zum Messen von Hochfrequenzsignalen mit normierter Stromversorgungs- und Datenschnittstelle zwischen Messgerät und Breitbandtastkopf,
- Fig. 2C: ein Blockdiagramm einer dritten Ausführungsform des erfindungsgemäßen Systems zum Messen von Hochfrequenzsignalen mit normierter Stromversorgungs- und Datenschnittstelle zwischen Messgerät und Breitbandtastkopf,
- Fig. 2D: ein Blockdiagramm einer vierten Ausführungsform des erfindungsgemäßen Systems zum Messen von Hochfrequenzsignalen mit normierter Stromversorgungs- und Datenschnittstelle zwischen Messgerät und Breitbandtastkopf,
- Fig. 2E: ein Blockdiagramm einer fünften Ausführungsform des erfindungsgemäßen Systems zum Messen von Hochfrequenzsignalen mit normierter Stromversorgungs- und Datenschnittstelle zwischen Messgerät und Breitbandtastkopf und
- Fig. 3: ein Layout der Adapterbaugruppe der ersten Ausführungsform des erfindungsgemäßen Systems zum Messen von Hochfrequenzsignalen mit normierter Stromversorgungs- und Datenschnittstelle zwischen Messgerät und Breitbandtastkopf.

In Fig. 2A ist eine erste Ausführungsform des erfindungsgemäßen Systems zum Messen von Hochfrequenzsignalen mit normierter Stromversorgungs- und Datenschnittstelle zwischen Messgerät und Breitbandtastkopf dargestellt.

Ein aktiver Breitbandtastkopf 2 erfasst ein Hochfrequenzsignal und überträgt es über einen dritten Hochfrequenzanschluss 6 - typischerweise ein BNC-Stecker - , der an einer zum Breitbandtastkopf gehörigen Anschlussbox 5 angeordnet ist, an einen auf der Adapterbaugruppe 1 angebrachten zweiten Hochfrequenzanschluss 8, typischerweise eine BNC-Buchse, die direkt mit dem dritten Hochfrequenzanschluss 6 des Breitbandtastkopf 2 verbunden ist (BNC-Stecker 6 des Breitbandtastkopfs 2 steckt in BNC-Buchse 8 der Adapterbaugruppe 1).

In der Adapterbaugruppe 1 erfolgt die elektrische Umsetzung und Verbindung vom zweiten Hochfrequenzanschluss 8 zum ersten Hochfrequenzanschluss 9, typischerweise ein SMA- oder N-Stecker, der in einem vierten Hochfrequenzanschluss (HF) 11 des Messgeräts 3, typischerweise eine SMA- oder N-Buchse, steckt. Über diese Verbindung wird das erfasste Hochfrequenzsignal zum Messgerät 3 übertragen.

Die Stromversorgungs- und Datensignalanschlüsse 12 des Messgeräts 3 sind bevorzugt nach dem Universal-Serial-Bus-Standard (USB - Standard) normiert. Sie weisen folglich in ihrer elektrischen Konfiguration eine Stromversorgungsleitung, eine Masseleitung und zwei Datensignalleitungen zum Austausch der seriell übertragenen Kommunikationsdaten und in ihrer mechanischen Konfiguration eine nach dem USB-Standard normierte Buchse zur Aufnahme eines USB-Steckers auf.

Über die Datensignalanschlüsse werden typischerweise folgende Daten übertragen:
- Kalibrierdaten
- vom Tastkopf bei der Kalibrierung erfasstes Gleichspannungs-Messsignal
- Gleichspannungs-Offset
- Verstärkungs- bzw. Dämpfungsfaktoren
- Typ des Breitbandtastkopfs
- Eingangswiderstand und -kapazität des Breitbandtastteilers
- Bandbreite und Frequenzgang des Breitbandtastkopfs
- Anstiegszeit des Breitbandtastkopfs
- Auswahl DC- oder AC-Kopplung
- Temperatur-Messwerte

Über eine erste elektrische Verbindungsleitung 13, die jeweils einen in die mechanischen Versorgungsspannungs- und Datensignalanschlüsse 12 des Messgeräts 3 und einen in erste Versorgungsspannungs- und Datensignalanschlüsse 14 der Adapterbaugruppe 1 passenden Stecker, bevorzugt einen USB-Stecker, besitzt, werden die Stromversorgung des Breitbandtastkopfs 2 und die Kommunikationsdaten zwischen Messgerät 3 und Breitbandtastkopf 2 über die Adapterbaugruppe 1 übertragen. In der Adapterbaugruppe 1 erfolgt die Umsetzung und Verbindung zwischen ersten mechanischen Versorgungsspannungs- und Datensignalanschlüssen 14 und zweiten mechanischen Versorgungsspannungs- und Datensignalanschlüssen 15, die zu den dritten mechanischen Versorgungsspannungs- und Datensignalanschlüssen 17 des Breitbandtastkopfes 2 passen. Über diese Verbindung werden die Stromversorgung des Breitbandtastkopfs 3 und die Kommunikationsdaten zwischen Adapterbaugruppe 1 und Breitbandtastkopf 2 übertragen.

Während in der ersten Ausführungsform des erfindungsgemäßen Systems zum Messen von Hochfrequenzsignalen mit normierter Stromversorgungs- und Datenschnittstelle zwischen Messgerät und Breitbandtastkopf gemäß Fig. 2A die Stromversorgung und die Kommunikationsdaten für den Breitbandtastkopf 2 im Messgerät 3 erzeugt und verarbeitet und über die ersten Versorgungsspannungs- und Datensignalanschlüsse 12 ausgegeben werden, erfolgt in einer zweiten Ausführungsform des erfindungsgemäßen Systems zum Messen von Hochfrequenzsignalen mit normierter Stromversorgungs- und Datenschnittstelle zwischen Messgerät und Breitbandtastkopf gemäß Fig. 2B die Erzeugung und Verarbeitung der Kommunikationsdaten und der Stromversorgung in einer Signalverarbeitungs-Einheit 3' und die Ausgabe der Stromversorgung und der Kommunikationsdaten über zugehörige erste Versorgungsspannungs- und Datensignalanschlüsse 12'.

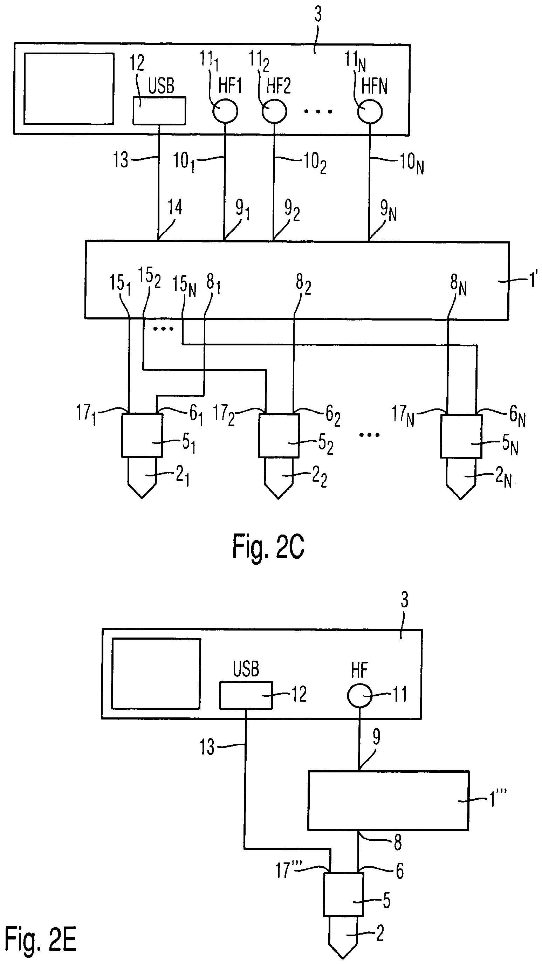

In Fig. 2c ist eine dritte Ausführungsform des erfindungsgemäßen Systems zum Messen von Hochfrequenzsignalen mit normierter Stromversorgungs- und Datenschnittstelle zwischen Messgeräten und Breitbandtastköpfen dargestellt.

Im Gegensatz zur ersten und zweiten Ausführungsform des erfindungsgemäßen Systems weist das Messgerät 3 der dritten Ausführungsform des erfindungsgemäßen Systems bis zu N vierten Hochfrequenzanschlüsse 11₁,11₂,..., 11_{N} auf, die über jeweils zweite elektrische Verbindungsleitungen 10₁, 10₂,...,10_{N} mit den bis zu N ersten Hochfrequenzanschlüssen 9₁, 9₂,...,9_{N} der Adapterbaugruppe 1' in elektrischer Verbindung stehen.

In der Adapterbaugruppe 1' sind die bis zu N ersten Hochfrequenzanschlüsse 9₁,9₂,...,9_{N} jeweils mit den bis N zweiten Hochfrequenzanschlüssen 8₁,8₂,...,8_{N} elektrisch verbunden, welche wiederum mit den N dritten Hochfrequenzanschlüssen 6₁,6₂,..,6_{N} der zu den bis N Breitbandtastköpfen 2₁,2₂,..,2_{N} jeweils gehörigen Anschlussboxen 5₁,5₂,..,5_{N} in Verbindung stehen.

Die Stromversorgung für die einzelnen Breitbandtastköpfe 2₁,2₂,..,2_{N} und die Kommunikationsdaten zwischen Messgerät 3 und den einzelnen Breitbandtastköpfen 2₁,2₂,..,2_{N} werden wie bei der ersten und zweiten Ausführungsform des erfindungsgemäßen Systems im Messgerät 3 über die Stromversorgungs- und Datensignalanschlüsse 12 und die erste Verbindungsleitung 13 an die ersten Stromversorgungs- und Datensignalanschlüsse 14 der Adapterbaugruppe 1' elektrisch übertragen. In der Adapterbaugruppe 1' erfolgt eine Verbindung der ersten Stromversorgungs- und Datensignalanschlüsse 14 an die bis zu N zweiten Stromversorgungs- und Datensignalanschlüsse 15₁, 15₂,...,15_{N}, welche mit den Stromversorgungs- und Datensignalanschlüssen 17₁,17₂,..,17_{N} der zu den bis N Breitbandtastköpfen 2₁,2₂,..,2_{N} jeweils gehörigen Anschlussboxen 5₁,5₂,..,5_{N} in Verbindung stehen. Anstelle der ersten Stromversorgungs- und Datensignalanschlüsse 14 und der bis zu N zweiten Stromversorgungs- und Datensignalanschlüsse 15₁,15₂,...,15_{N} der Adapterbaugruppe 1' kann bei Verwendung eines USB-Schnittstellenstandards alternativ auch ein USB-Hub verwendet werden.

Theoretisch können in der dritten Ausführungsform des erfindungsgemäßen Systems auf diese Weise standardmäßig bis zu 128 Breitbandtastköpfe 2₁, 2₂,..,2₁₂₈ an das Messgerät angeschlossen werden, sofern eine entsprechende Anzahl von Hochfrequenzanschlüssen bzw. eine entsprechend erforderliche Signalverarbeitungskapazität am Messgerät 3 vorhanden ist.

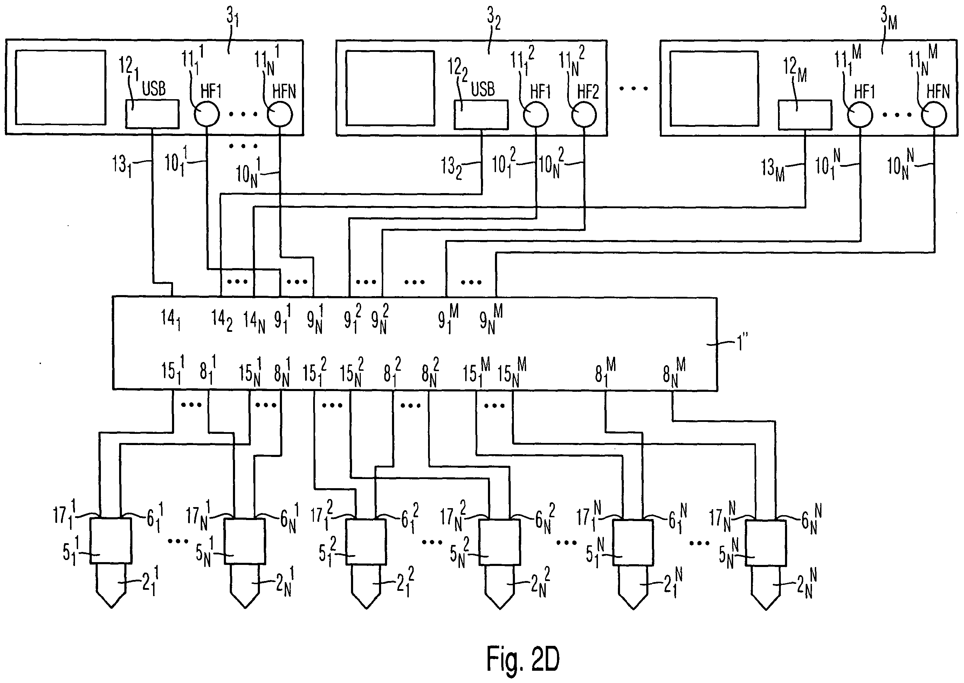

In Fig. 2D ist eine vierte Ausführungsform des erfindungsgemäßen Systems zum Messen von Hochfrequenzsignalen mit normierter Stromversorgungs- und Datenschnittstelle zwischen Messgeräten und Breitbandtastköpfen dargestellt.

Im Gegensatz zur ersten, zweiten und dritten Ausführungsform des erfindungsgemäßen Systems sind mehrere, bis zu M, Messgeräte 3₁,3₂,...,3_{M} mit jeweils bis zu N Hochfrequenzanschlüssen 11₁¹,...,11_{N}¹,11₁²,...,11_{N}²,...,11₁^{M},...,11_{N}^{M} vorhanden, die über jeweils zweite elektrische Verbindungsleitungen 10₁¹,...,10_{N}¹,10₁²,...,10_{N}²,...,10₁^{M},...,10_{N}^{M} mit den bis zu *N*·*M* ersten Hochfrequenzanschlüssen 9₁¹,..., 9_{N}¹,9₁²,...,9_{N}²,...,9₁^{M},...,9_{N}^{M} in elektrischer Verbindung stehen.

In der Adapterbaugruppe 1" sind die bis zu *N*·*M* ersten Hochfrequenzanschlüsse 9₁¹,...,9_{N}¹, 9₁²,...,9_{N}²,...,9₁^{M},...,9_{N}^{M} jeweils mit den bis *N*·*M* zweiten Hochfrequenzanschlüssen 8₁¹,...,8_{N}¹,8₁²,...,8_{N}²,...,8₁^{M},...,8_{N}^{M} elektrisch verbunden, welche wiederum mit den Hochfrequenzanschlüssen 6₁¹,...,6_{N}¹,6₁²,...,6_{N}²,...,6₁^{M},...,6_{N}^{M} der zu den bis *N*·*M* Breitbandtastköpfen 2₁¹,...,2_{N}¹,2₁²,...,2_{N}²,...,2₁^{M},...,2_{N}^{M} jeweils gehörigen Anschlussboxen 5₁¹,...,5_{N}¹,5₁²,...,5_{N}²,...,5₁^{M},..., 5_{N}^{M} in elektrischer Verbindung stehen.

Die Stromversorgung für die einzelnen Breitbandtastköpfe 2₁¹,...,2_{N}¹, 2₁²,...,2_{N}²,...,2₁^{M},...,2_{N}^{M} und die Kommunikationsdaten zwischen Messgerät(en) (3) bzw. der Signalverarbeitungseinheit (3')und den einzelnen Breitbandtast köpfen 2₁¹,...,2_{N}¹,2₁²,...,2_{N}²,...,2₁^{M},...,2_{N}^{M} werden wie in der ersten, zweiten und dritten Ausführungsform des erfindungsgemäßen Systems von den Messgeräten 3₁,3₂,..., 3_{M} bzw. von der in der Signalverarbeitungs-Einheit 3' über die Stromversorgungs- und Datensignalanschlüsse 12₁,12₂,...,12_{M} bzw. 12' und die dritten Verbindungsleitungen 13₁,13₂,...,13_{M} an die ersten Stromversorgungs- und Datensignalanschlüsse 14₁,14₂,...,14_{M} der Adapterbaugruppe 1" elektrisch übertragen. In der Adapterbaugruppe 1" erfolgt eine Verbindung der ersten Stromversorgungs- und Datensignalanschlüsse 14₁,14₂,...,14_{M} an die bis zu *N*·*M* zweiten Stromversorgungs- und Datensignalanschlüsse 15₁¹,...,15_{N}¹,15₁²,...,15_{N}²,...,15₁^{M},...,15_{N}^{M}, welche wiederum mit den Stromversorgungs- und Datensignalanschlüssen 17₁¹,...,17_{N}¹,17₁²,...,17_{N}²,...,17₁^{M},...,17_{N}^{M} der zu den bis *N*·*M* Breitbandtast köpfen 2₁¹,...,2_{N}¹,2₁²,...,2_{N}²,...,2₁^{M},...,2_{N}^{M} jeweils gehörigen Anschlussboxen 5₁¹,...,5_{N}¹,5₁²,5_{N}²,...,5₁^{M},...,5_{N}^{M} in Verbindung stehen.

Anstelle der bis zu M ersten Stromversorgungs- und Datensignalanschlüsse 14₁,14₂,...,14_{M} und der bis zu *N*·*M* zweiten Stromversorgungs- und Datensignalanschlüsse 15₁¹,...,15_{N}¹,15₁²,...,15_{N}²,...,15₁^{M},...,15_{N}^{M} der Adapterbaugruppe 1" können bei Verwendung eines USB-Schnittstellenstandards alternativ auch M USB-Hubs verwendet werden. Theoretisch können in der vierten Ausführungsform des erfindungsgemäßen Systems auf diese Weise standardmäßig bis zu 128 Breitbandtastköpfe 2₁,2₂,..,2₁₂₈ an jeweils ein Messgerät 3₁,3₂,...,3_{M} oder eine Signalverarbeitungs-Einheit 3' angeschlossen werden, sofern eine entsprechende Anzahl von Hochfrequenzanschlüssen bzw. eine entsprechend erforderliche Signalverarbeitungskapazität am jeweiligen Messgerät 3₁,3₂,...,3_{M} vorhanden ist.

In Fig. 2E ist eine fünfte Ausführungsform des erfindungsgemäßen Systems zum Messen von Hochfrequenzsignalen mit normierter Stromversorgungs- und Datenschnittstelle zwischen Messgerät und Breitbandtastkopf dargestellt.

Im Gegensatz zur ersten, zweiten, dritten und vierten Ausführungsform des erfindungsgemäßen Systems weist die zum Breitbandtastkopf 3 gehörige Anschlussbox 5 Versorgungsspannungs- und Datensignalanschlüsse 17''' auf, die hinsichtlich ihrer elektrischen und mechanischen Konfiguration passend zur elektrischen und mechanischen Konfiguration der Versorgungsspannungs- und Datensignalanschlüsse 12 bzw. 12' des Messgeräts 3 bzw. der Signalverarbeitungs-Einheit 3' sind und insbesondere wie das Messgerät 3 bzw. die Signalverarbeitungs-Einheit 3' Versorgungsspannungs- und Datensignalanschlüsse nach dem USB-Standard aufweisen. Die erste elektrische Verbindungsleitung 13 erstreckt sich folglich von den Versorgungsspannungs- und Datensignalanschlüsse 12 bzw. 12' des Messgeräts 3 bzw. der Signalverarbeitungs-Einheit 3' bis zu den Versorgungsspannungs- und Datensignalanschlüssen 17''' der zum Breitbandtastkopf 3 gehörigen Anschlussbox 5. An der zur fünften Ausführungsform des erfindungsgemäßen Systems gehörigen Adapterbaugruppe 1''' entfallen die ersten und zweiten Versorgungsspannungs- und Datensignalanschlüsse 14 und 15 der Adapterbaugruppe 1 und die vierte elektrische Verbindungsleitung 16 zwischen Adapterbaugruppe 1 und Anschlussbox 5 der ersten Ausführungsform des erfindungsgemäßen Systems.

Werden in Kombination der dritten und fünften Ausführungsform des erfindungsgemäßen Systems ausschließlich oder teilweise Breitbandtastköpfe 2₁, 2₂,..,2_{N} verwendet, deren Versorgungsspannungs- und Datensignalanschlüsse 17₁,17₂,..,17_{N} hinsichtlich ihrer elektrischen und mechanischen Konfiguration identisch zur elektrischen und mechanischen Konfiguration der Versorgungsspannungs- und Datensignalanschlüsse 12 des Messgeräts 3 sind und insbesondere wie das Messgerät 3 Versorgungsspannungs- und Datensignalanschlüsse nach dem USB-Standard aufweisen, so wird die erste elektrische Verbindungsleitung 13, die mit den Versorgungsspannungs- und Datensignalanschlüssen 12 des Messgeräts 3 verbunden ist, an einen Datenleitungssplitter, beispielsweise einen USB-Hub bei Verwendung der USB-Schnittstelle, geführt. Die Ausgänge des Datenleitungssplitter werden über elektrische Verbindungsleitungen direkt an diejenigen Versorgungsspannungs- und Datensignalanschlüsse 17₁,17₂, ..,17_{N} der Breitbandtastköpfe 2₁,2₂,..,2_{N}, die hinsichtlich ihrer elektrischen und mechanischen Konfiguration Identität zu den Versorgungsspannungs- und Datensignalanschlüssen 12 des Messgeräts 3 aufweisen, und indirekt über die ersten und zweiten Versorgungsspannungs- und Datensignalanschlüsse 14 und 15₁,15₂,...,15_{N} der Adapterbaugruppe 1' an diejenigen Versorgungsspannungs- und Datensignalanschlüsse 17₁,17₂,..,17_{N} der Breitbandtastköpfe 2₁,2₂,..,2_{N} geführt, die keine Identität hinsichtlich ihrer mechanischen Konfiguration zu den Versorgungsspannungs- und Datensignalanschlüssen 12 des Messgeräts 3 aufweisen. Alle Schnittstellen sind elektrisch identisch.

Analog werden in Kombination der vierten und fünften Ausführungsform des erfindungsgemäßen Systems die ersten elektrischen Verbindungsleitungen 13₁,13₂,...,13_{M} jeweils an einen Datenleitungssplitter, beispielsweise einen USB-Hub bei Verwendung der USB-Schnittstelle, geführt, falls Breitbandtastköpfe 2₁¹,...,2_{N}¹,2₁²,...,2_{N}²,...,2₁^{M},...,2_{N}^{M} zum Einsatz kommen, die hinsichtlich ihrer elektrischen und mechanischen Konfiguration identisch zu den Versorgungsspannungs- und Datensignalanschlüssen 12₁,12₂,...,12_{M} der Messgeräte 3₁,3₂,...,3_{M} ausgelegt sind. Die Ausgänge der Datenleitungssplitter werden analog über elektrische Verbindungsleitungen direkt an diejenigen Versorgungsspannungs- und Datensignalanschlüsse 17₁¹,...,17_{N}¹,17₁²,...,17_{N}²,...,17₁^{M},...,17_{N}^{M} der bis *N*·*M* Breitbandtastköpfe 2₁¹,...,2_{N}¹,2₁²,...,2_{N}²,...,2₁^{M},...,2_{N}^{M}, die hinsichtlich ihrer elektrischen und mechanischen Konfiguration Identität zu den zugehörigen Versorgungsspannungs- und Datensignalanschlüssen 12₁,12₂,...,12_{M} der zum jeweiligen Breitbandtastkopf 2₁¹,...,2_{N}¹, 2₁²,...,2_{N}²,...,2₁^{M},...,2_{N}^{M} jeweils gehörigen Messgeräte 3₁,3₂,...,3_{M} aufweisen, und indirekt über die ersten und zweiten Versorgungsspannungs- und Datensignalanschlüsse 14₁,14₂,...,14_{M} und 15₁¹,...,15_{N}¹, 15₁²,...,15_{N}²,...,15₁^{M},...,15_{N}^{M} der Adapterbaugruppe 1" an diejenigen Versorgungsspannungs- und Datensignalanschlüsse 17₁¹,...,17_{N}¹,17₁²,...,17_{N}²,...,17₁^{M},..., 17_{N}^{M} der bis *N*·*M* Breitbandtastköpfe 2₁¹,...,2_{N}¹,2₁²,...,2_{N}²,..., 2₁^{M},...,2_{N}^{M} geführt, die keine Identität hinsichtlich ihrer mechanischen Konfiguration zu den Versorgungsspannungs- und Datensignalanschlüssen 12₁,12₂,...,12_{M} der zum jeweiligen Breitbandtastkopf 2₁¹,...,2_{N}¹,2₁²,...,2_{N}²,...,2₁^{M},...,2_{N}^{M} jeweils gehörigen Messgeräte 3₁,3₂,...,3_{M} aufweisen.

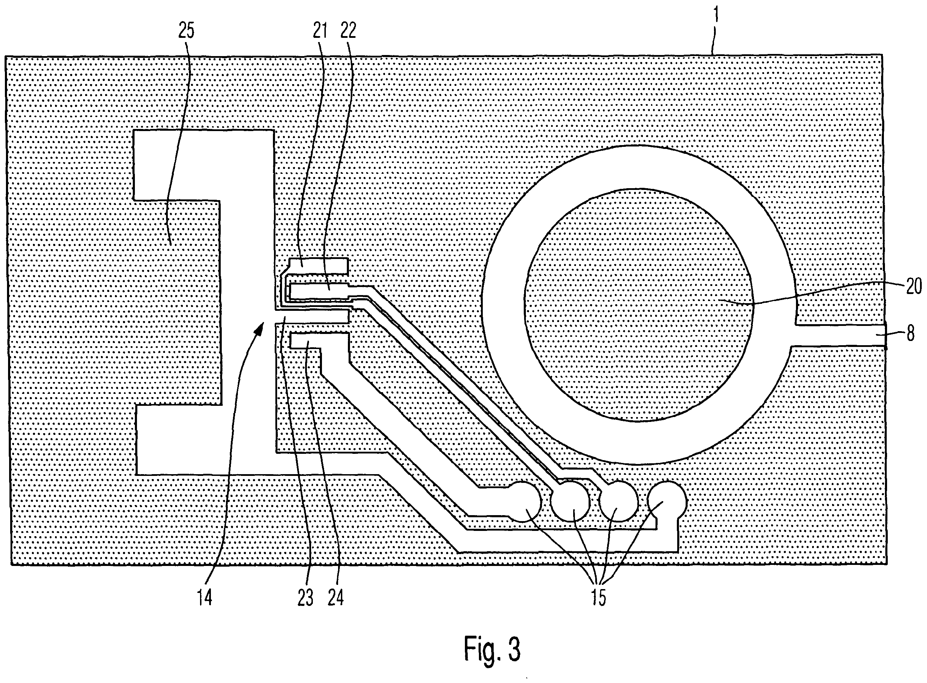

In Fig. 3 ist ein beispielhaftes Layout der zur ersten Ausführungsform des erfindungsgemäßen Systems gehörigen Adapterbaugruppe 1 dargestellt.

Zu erkennen ist in der rechte Hälfte des Platinen-Layouts ein kreisrunder Ausschnitt 20 für den tastkopfseitigen zweiten Hochfrequenzanschluss 8, in der linken Hälfte des Layouts die Anschluss-Pads für die als USB-Buchse ausgelegten ersten Versorgungsspannungs- und Datensignalanschlüssen 14 - von oben nach unten mit den beiden Datenleitungsanschlüssen 21 und 22, dem Masseanschluss 23 und dem Versorgungsspannungsanschluss 24 - und unten rechts im Layout die mit den ersten Versorgungsspannungs- und Datensignalanschlüssen 14 elektrisch verbundenen zweiten Versorgungsspannungs- und Datensignalanschlüsse 15, die jeweils mit einer der Datenleitungsanschlüsse 21 oder 22 oder mit Masseanschluss 23 oder mit dem Versorgungsanschluss 24 verbunden sind. Der Masseanschluss 23 ist U-förmig zur Aufnahme der Schirmung der USB-Buchse ausgelegt. Der kreisrunde Ausschnitt 20 wird in einem späteren Fertigungsschritt in die mit Leiterbahnen bzw. Leiterfläche beschichtete Platine 26 eingebracht. Auf der Rückseite befindet sich vorzugsweise eine vollflächig ausgebildete Massefläche. Die Platine 26 wird vertikal zur den ersten und zweiten Hochfrequenzanschlüssen 8 und 9 in die Adapterbaugruppe 9 eingebaut.

Anstelle oder zusätzlich zu einem Messgerät 3 bzw. 3₁,3₂,...,3_{M} kann in Analogie zur zweiten Ausführungsform in Fig. 2B in allen übrigen Ausführungsformen des erfindungsgemäßen Systems alternativ auch eine Signalverarbeitungs-Einheit 3 bzw. 3₁,3₂,...,3_{M}, beispielsweise ein Personal Computer, ein Laptop, ein Server und/oder ein Microcontroller-Board oder andere Prozessrechner zum Einsatz kommen, die Versorgungsspannungs- und Datensignalanschlüsse, insbesondere nach dem USB-Standard, eine Signalverarbeitungs-Einheit zur digitalen Signalverarbeitung der erfassten Gleichspannungs-Messsignale, zur Ansteuerung, zur Durchführung einer Kalibrierung der Breitbandtastköpfe und zur Spannungsversorgung der aktiven Breitbandtastköpfe und eine Display-Einheit zur Darstellung der erfassten Gleichspannungs-Messsignale sowie von Statusinformationen der verwendeten Breitbandtastköpfe aufweist.

Für eine erfolgreiche Stromversorgung der einzelnen aktiven Breitbandtastköpfe und eine erfolgreiche Datenkommunikation zwischen den einzelnen Breitbandtastköpfen und den einzelnen Messgeräten bzw. Signalverarbeitungs-Einheiten ist beim Einschalten des(r) Messgeräts(e) sowie der Signalverarbeitungs-Einheit(en) in der Boot-Phase des jeweiligen Geräts eine zum jeweiligen Breitbandtastkopf gehörige Treiber-Software zu laden, um ein fehlerfreies Zusammenwirken zwischen Mess-Hardware und Applikations-Software - hier Messsignalverarbeitung - zu garantieren.

Die Erfindung ist nicht auf die dargestellten Ausführungsformen des erfindungsgemäßen Systems beschränkt. Von der Erfindung sind neben der heute etablierten Universal-Serial-Bus-Schnittstelle insbesondere auch zukünftig zum Einsatz kommende Datenübertragungsschnittstellen, die genormt sind und einen Standard im Industrie- und Telekommunikationsbereich darstellen, abgedeckt.

## Patentansprüche

1. System zum Messen von mindestens einem Hochfrequenzsignal, wobei besagtes System mindestens einen aktiven Breitbandtastkopf (2) und mindestens ein Messgerät (3) umfasst und wobei jeder aktive Breitbandtastkopf (2) und jedes Messgerät (3) zum Übertragen eines jeweiligen Hochfrequenzsignals jeweils einen Hochfrequenzanschluss (6,11) und jedes Messgerät (3) oder jede anstelle eines Messgeräts (3) jeweils verwendete Signalverarbeitungs-Einheit (3') und jeder aktive Breitbandtastkopf (2) zur Stromversorgung jedes der aktiven Breitbandtastköpfe (2) jeweils Stromversorgungsanschlüsse (12) und zur Übertragung von Kommunikationsdaten zwischen Messgerät (3) oder Signalverarbeitungs-Einheit (3') und Breitbandtastkopf (2) jeweils Datensignalanschlüsse (12) aufweisen, wobei die Signalbelegung und Signalspezifikation aller Stromversorgungs- und Datensignalanschlüsse (12) jedes Messgeräts (3), jeder Signalverarbeitungs-Einheit (3') und jedes aktiven Breitbandtastkopfs (2) identisch sind und gemäß einem Schnittstellenstandard ausgelegt sind,
**dadurch gekennzeichnet,**
**dass** die Stromversorgungs- und Datensignalanschlüsse in ihrer elektrischen und mechanischen Konfiguration in jedem Messgerät (3), in jeder Signalverarbeitungs-Einheit (3') und entweder direkt im Breitbandtastkopf (2) oder in einer Adapterbaugruppe (1), die mit dem Breitbandtastkopf (2) über eine Verbindungsleitung mit breitbandtastkopfseitigen und adapterbaugruppenseitigen Stromversorgungs- und Datensignalanschlüssen elektrisch verbunden ist, identisch sind und jeweils eine nach dem USB-Standard normierte Buchse zur Aufnahme eines nach dem USB-Standard normierten Steckers aufweisen.

2. System nach Anspruch 1,
**dadurch gekennzeichnet,**
**dass** die Adapterbaugruppe (1) eine passive Baugruppe ohne eigene Stromversorgung ist.

3. System nach Anspruch 1 oder 2,
**dadurch gekennzeichnet,**
**dass** die Adapterbaugruppe (1) jeweils erste Stromversorgungs- und Datensignalanschlüsse (14), die mit den Stromversorgungs- und Datensignalanschlüssen (12) des(r) jeweiligen Messgeräts(e) (3) oder der jeweiligen Signalverarbeitungs-Einheit(en) (3') elektrisch verbunden sind und in der einzigen identisch genormten Buchse geführt sind, und jeweils mit den ersten Stromversorgungs- und Datensignalanschlüssen (14) elektrisch verbundene zweite Stromversorgungs- und Datensignalanschlüsse (15) aufweist, die mit den Stromversorgungs- und Datensignalanschlüssen (17) des(r) jeweiligen aktiven Breitbandtastko(ö)pfs(e) (2) elektrisch verbunden sind.

4. System nach Anspruch 3,
**dadurch gekennzeichnet,**
**dass** die ersten Stromversorgungs- und Datensignalanschlüsse (14) und die Stromversorgungs- und Datensignalanschlüsse (12,17)jedes Messgeräts (3), jeder Signalverarbeitungs-Einheit (3') und des(r)jenigen aktiven Breitbandtastko(ö)pfs(e) (2) nach dem Universal-Serial-Bus-Standard (USB-Standard) genormt sind.

5. System nach Anspruch 3 oder 4,
**dadurch gekennzeichnet,**
**dass** zwischen dem(n)jenigen Messgerät(en) (3) und dem(n)jenigen aktiven Breitbandtastko(ö)pf(en) (2), die jeweils unterschiedliche Hochfrequenzanschlüsse (11,6) aufweisen, die Adapterbaugruppe (1) jeweils (einen) erste(n) Hochfrequenzanschlu(ü)ss(e) (9) zum elektrischen Verbinden mit dem(n) Hochfrequenzanschlu(ü)ss(en) (11) des(r) Messgeräts(e) (3) und jeweils mit dem(n) ersten Hochfrequenzanschlu(ü)ss(en) (9) elektrisch verbundene(n) zweite(n) Hochfrequenzanschlu(ü)ss(e) (8) zum elektrischen Verbinden mit dem(n) Hochfrequenzanschlu(ü)ss(en) (6) des(r) jeweiligen aktiven Breitbandtastkö(o)pfe(s) (2) aufweist.

6. System nach Anspruch 5,
**dadurch gekennzeichnet,**
**dass** jeder mit dem jeweiligen Hochfrequenzanschluss (11) des Messgeräts (3) jeweils elektrisch verbundene erste Hochfrequenzanschluss (9) der Adapterbaugruppe (1) ein dem Hochfrequenzanschluss (11) des Messgeräts (3) entsprechender Hochfrequenzanschluss, insbesondere ein SMA- oder N- Hochfrequenzanschluss, ist.

7. System nach Anspruch 5 oder 6,
**dadurch gekennzeichnet,**
**dass** der mit dem jeweiligen Hochfrequenzanschluss (6) des aktiven Breitbandtastkopfs (2) jeweils elektrisch verbundene zweite Hochfrequenzanschluss (8) der Adapterbaugruppe (1) ein dem Hochfrequenzanschluss (6) des aktiven Breitbandtastkopfs (2) entsprechender Hochfrequenzanschluss, insbesondere ein BNC-Hochfrequenzanschluss, ist.

8. System nach einem der Ansprüche 1 bis 7,
**dadurch gekennzeichnet,**
**dass** die Signalverarbeitungs-Einheit (3') ein Personal Computer, Laptop, Server und/oder Micro-Controller-Board mit einer integrierten Universal-Serial-Bus-(USB)-Schnittstelle ist.

## Claims

1. System for measuring at least one high-frequency signal, wherein said system comprises at least one active broad band sampling head (2) and at least one measuring device (3) and wherein each active broad band sampling head (2) and each measuring device (3) in each case have a high frequency port (6, 11) for transmitting a respective high-frequency signal, and each measuring device (3) or each signal processing unit (3') used in place of a measuring device (3) in each case and each active broad band sampling head (2) in each case have power supply ports (12) for the power supply of each of the active broad band sampling heads (2) and in each case have data signal ports (12) for transmission of communications data between the measuring device (3) or signal processing unit (3') and broad band sampling head (2), wherein the signal assignment and signal specification of all the power supply and data signal ports (12) of each measuring device (3), of each signal processing unit (3') and of each active broad band sampling head (2) are identical and are designed according to one interface standard,
**characterised in that**
the power supply and data signal ports are identical in their electrical and mechanical configuration in each measuring device (3), in each signal processing unit (3') and either directly in the broad band sampling head (2) or in an adapter assembly (1) which is connected electrically with the broad band sampling head (2) by means of a connecting lead with power supply and data signal ports on the broad band sampling head side and the adapter assembly side, and in each case have a socket standardised according to the USB standard to receive a plug standardised according to the USB standard.

2. System according to claim 1,
**characterised in that**
the adapter assembly (1) is a passive assembly without its own power supply.

3. System according to claim 1 or 2,
**characterised in that**
the adapter assembly (1) in each case has first power supply and data signal ports (14) which are connected electrically with the power supply and data signal ports (12) of the respective measuring device or devices (3) or the respective signal processing unit or units (3') and run in the single identically standardised socket, and in each case has second power supply and data signal ports (15) which are connected electrically with the first power supply and data signal ports (14) and are connected electrically with the power supply and data signal ports (17) of the respective active broad band sampling head or heads (2).

4. System according to claim 3,
**characterised in that**
the first power supply and data signal ports (14) and the power supply and data signal ports (12, 17) of each measuring device (3), of each signal processing unit (3') and of the active broad band sampling head or heads (2) are standardised according to the universal serial bus standard (USB standard).

5. System according to claim 3 or 4,
**characterised in that**
between the measuring device or devices (3) and the active broad band sampling head or heads (2) which in each case have different high-frequency ports (11, 6), the adapter assembly (1) has in each case (one) first high frequency port or ports (9) for electrical connection with the high frequency port or ports (11) of the measuring device or devices (3) and in each case a second high frequency port or ports (8) connected electrically with the first high frequency port or ports (9) for electrical connection with the high frequency port or ports (6) of the respective active broad band sampling head or heads (2).

6. System according to claim 5,
**characterised in that**
each first high frequency port (9) of the adapter assembly (1) in each case connected electrically with the respective high frequency port (11) of the measuring device (3) is a high frequency port, in particular an SMA or N high frequency port, corresponding to the high frequency port (11) of the measuring device (3).

7. System according to claim 5 or 6,
**characterised in that**
the second high frequency port (8) of the adapter assembly (1) in each case connected electrically with the respective high frequency port (6) of the active broad band sampling head (2) is a high frequency port, in particular a BNC high frequency port, corresponding to the high frequency port (6) of the active broad band sampling head (2).

8. System according to one of claims 1 to 7,
**characterised in that**
the signal processing unit (3') is a personal computer, laptop, server and/or micro-controller board with an integrated universal serial bus (USB) interface.

## Revendications

1. Système de mesure d'au moins un signal à haute fréquence, dans lequel ledit système comprend au moins une sonde à large bande (2) active et au moins un appareil de mesure (3) et dans lequel chaque sonde à large bande (2) active et chaque appareil de mesure (3) présentent pour la transmission d'un signal à haute fréquence respectif respectivement un connecteur à haute fréquence (6, 11), et chaque appareil de mesure (3) ou chaque unité de traitement de signal (3') respectivement utilisée à la place d'un appareil de mesure (3) et chaque sonde à large bande (2) active présentent pour l'alimentation électrique de chacune des sondes à large bande (2) actives respectivement des bornes d'alimentation électrique (12) et pour la transmission de données de communication entre appareil de mesure (3) ou unité de traitement de signal (3') et sonde à large bande (2) respectivement des bornes de signal de données (12),
dans lequel l'affectation de signal et la spécification de signal de toutes les bornes d'alimentation électrique et de signal de données (12) de chaque appareil de mesure (3), de chaque unité de traitement de signal (3') et de chaque sonde à large bande (2) active sont identiques et sont conçues conformément à une norme d'interface, **caractérisé en ce que**
les bornes d'alimentation électrique et de signal de données dans leur configuration électrique et mécanique dans chaque appareil de mesure (3), dans chaque unité de traitement de signal (3') et soit directement dans la sonde à large bande (2) active soit dans un assemblage d'adaptateurs (1) qui est électriquement relié à la sonde à large bande (2) via un conduit de liaison avec des bornes d'alimentation électrique et de signal de données situées sur les côtés de la sonde à large bande et des assemblages d'adaptateurs, sont identiques et présentent respectivement une prise femelle conforme à la norme USB destinée à recevoir une prise mâle conforme à la norme USB.

2. Système selon la revendication 1,
**caractérisé en ce que**
l'assemblage d'adaptateurs (1) est un assemblage passif sans sa propre alimentation électrique.

3. Système selon la revendication 1 ou 2,
**caractérisé en ce que**
l'assemblage d'adaptateurs (1) présente respectivement des premières bornes d'alimentation électrique et de signal de données (14) qui sont électriquement reliées aux bornes d'alimentation électrique et de signal de données (12) du/des appareil(s) de mesure (3) respectif(s) ou de la/des unité(s) de traitement de signal (3') respective(s), et qui sont conduites dans l'unique prise femelle normalisée à l'identique, et présente respectivement, électriquement reliées aux premières bornes d'alimentation électrique et de signal de données (14), des secondes bornes d'alimentation électrique et de signal de données (15) qui sont électriquement reliées aux bornes d'alimentation électrique et de signal de données (17) de la/des sonde(s) à large bande (2) active(s) respective(s).

4. Système selon la revendication 3,
**caractérisé en ce que**
les premières bornes d'alimentation électrique et de signal de données (14) et les bornes d'alimentation électrique et de signal de données (12, 17) de chaque appareil de mesure (3), de chaque unité de traitement de signal (3') et de celle(s) des sondes à large bande (2) actives sont normalisées conformément à la norme « bus universel en série » (norme USB).

5. Système selon la revendication 3 ou 4,
**caractérisé en ce qu'**
entre celui/ceux des appareils de mesure (3) et celle(s) des sondes à large bande (2) actives, qui présentent respectivement des connecteurs à haute fréquence (11, 6) différents, l'assemblage d'adaptateurs (1) présente respectivement un/des premier(s) connecteur(s) à haute fréquence (9) en vue d'établir une liaison électrique avec le(s) connecteur(s) à haute fréquence (11) du/des appareil(s) de mesure (3), et présente respectivement un/des second(s) connecteur(s) à haute fréquence (8) électriquement relié(s) au(x) premier(s) connecteur(s) à haute fréquence (9) en vue d'établir une liaison électrique avec le(s) connecteur(s) à haute fréquence (6) de la/des sonde(s) à large bande (2) active(s) respective(s).

6. Système selon la revendication 5,
**caractérisé en ce que**
chaque premier connecteur à haute fréquence (9) de l'assemblage d'adaptateurs (1) respectivement électriquement relié au connecteur à haute fréquence (11) respectif de l'appareil de mesure (3) est un connecteur à haute fréquence correspondant au connecteur à haute fréquence (11) de l'appareil de mesure (3), en particulier un connecteur à haute fréquence SMA- ou N-.

7. Système selon la revendication 5 ou 6,
**caractérisé en ce que**
le second connecteur à haute fréquence (8) de l'assemblage d'adaptateurs (1) respectivement électriquement relié au connecteur à haute fréquence (6) respectif de la sonde à large bande (2) active est un connecteur à haute fréquence correspondant au connecteur à haute fréquence (6) de la sonde à large bande (2) active, en particulier un connecteur à haute fréquence BNC-.

8. Système selon l'une quelconque des revendications 1 à 7,
**caractérisé en ce que**
l'unité de traitement de signal (3') est un ordinateur personnel, un ordinateur portable, un serveur et/ou une carte microcontrôleur avec une interface intégrée « bus universel en série » (USB).
